# EUROPEAN PATENT SPECIFICATION

(11) **EP 2 761 674 B1**
(45) Date of publication and mention of the grant of the patent: **06.01.2016**
(21) Application number: 12770344.5
(22) Date of filing: 13.09.2012
(51) Int. Cl.: H01L 31/05

(54) **PHOTOVOLTAIC CELL INTERCONNECT**
VERBINDUNGSSTRUKTUR VON SOLARZELLEN
INTERCONNEXION DE CELLULE PHOTOVOLTAÏQUE

(30) Priority: 29.09.2011 US 201161540720 P
(43) Date of publication of application: 06.08.2014
(73) Proprietor: Dow Global Technologies LLC, Midland, MI 48674 (US)
(72) Inventor: DEGROOT, Marty, W., Middletown, DE 19709 (US); CLARK, Lindsey, A., Midland, MI 48642 (US); FEIST, Rebekah, K., Midland, MI 48642 (US); LOPEZ, Leonardo, C., Midland, MI 48640 (US); NAMJOSHI, Abhijit, A., Midland, MI 48640 (US)
(74) Representative: Beck Greener
(86) International application number: PCT/US2012/055122
(87) International publication number: WO 2013/048759

(56) References cited:
- EP-A1- 1 981 091
- EP-A1- 2 012 364
- WO-A1-2009/097161
- DE-A1- 10 230 392
- US-A1- 2007 235 077
- US-A1- 2007 283 996
- US-B1- 6 184 457

## Description

### Field of the Invention

This invention relates generally to interconnected photovoltaic cells and modules and particularly to an improved approach to maintaining good interconnect performance throughout useful life of the cells or module.

### Introduction

Photovoltaic cells typically comprise a photoactive portion that converts light energy to electricity. On the backside of these cells is found a backside electrode and on the front side another electrical collection system. It is common for these cells to be connected in series by multiple thin wires or ribbons that contact the front side of a first cell and the back side on an adjacent cell. This interconnect configuration is commonly referred to as 'string & tab'. Typically an electrically conductive adhesive (ECA) or solder is used to attach the interconnect ribbon to the front and back sides of the adjacent cells.

These interconnect configurations are commonly used with flexible photovoltaic cells such as copper chalcogenide type cells (e.g. copper indium gallium selenides, copper indium selenides, copper indium gallium sulfides, copper indium sulfides, copper indium gallium selenides sulfides, etc.), amorphous silicon cells, crystalline silicon cells, thin-film III-V cells, organic photovoltaics, nanoparticle photovoltaics, dye sensitized solar cells, and combinations of the like.

WO 2009/097161 teaches strings of cells that are electrically joined by conductive tabs or ribbons adhered with an electrically conductive adhesive on the front and back of adjacent cells. This reference indicates that selecting the coefficient of thermal expansion of the ribbon or tab to match the substrate material and the semiflexible nature of the ECA minimizes mechanical stresses decreasing possibility of adhesion failure. US2007/0235077 discloses a solar cell wherein a solder fillet reduces the stress at the interconnection between a connection tab and a bus bar electrode.

Other examples of approaches to interconnection include US 2009/0266398, US 2009/0260675, U.S. 7,732,229, US 2005/0263179, US 2008/0216887, US 2009/00025788, US 2008/0011350, US 7,432,438, US 6,936,761; US 2007/0251570 and US.S. 7,022,910.

The industry continues to examine alternative approaches to improve interconnection.

### Summary of Invention

Notwithstanding the teachings of WO 2009/097161, the present inventors have discovered that with environmental stress (e.g., ambient heating) device performance degraded. Specifically, the applicants discovered electrical contacts in the interconnected cell string are susceptible to increased electrical resistance after environmental exposure. Upon further examination, applicants found a partial loss of electrical contact between the back conductive electrode and the electrical connector (e.g. conductive ribbon).

Thus, according to one aspect, the invention is a photovoltaic article comprising a first photovoltaic cell having a photoelectrically active region which is located between a topside electrode and a backside electrode, and an electrical connector in contact with the backside electrode on the backside of the cell, wherein an electrically conductive patch is located over at least a portion of both the backside electrode and the connector.

Preferably, the photovoltaic article is a string of at least two such photovoltaic cells where the electrical connector in contact with the backside electrode of the first photovoltaic cell as described above extends beyond the edge of that cell and is in contact with an electrically conductive portion of an adjacent cell, preferably in contact with a topside electrode of an adjacent cell. More preferably, the article has three or more such cells each having an electrical connector in contact with the backside electrode of one cell and also in contact with the front side electrode of an adjacent cell wherein for at least one electrical connector in contact with a backside electrode there is an electrically conductive patch located over at least a portion of both the backside electrode and the connector. More preferably still there is an electrically conductive patch located over at least a portion of both the backside electrode and the connector for each connector.

According to a second embodiment, the photovoltaic article as described above is packaged in a module suitable for electrical connection to other electronic devices and/or suitable for mounting on for generation and collection of electricity.

### Brief Description of the Drawings

Fig. 1 is a schematic showing the frontside view of a representative electrical connection from one photovoltaic cell to an adjacent photovoltaic cell.
Fig. 2 is a schematic showing the backside view of a representative electrical connection from one photovoltaic cell to an adjacent photovoltaic cell with a conductive patch over a portion of the backside electrode and electrical connector.

### Detailed Description

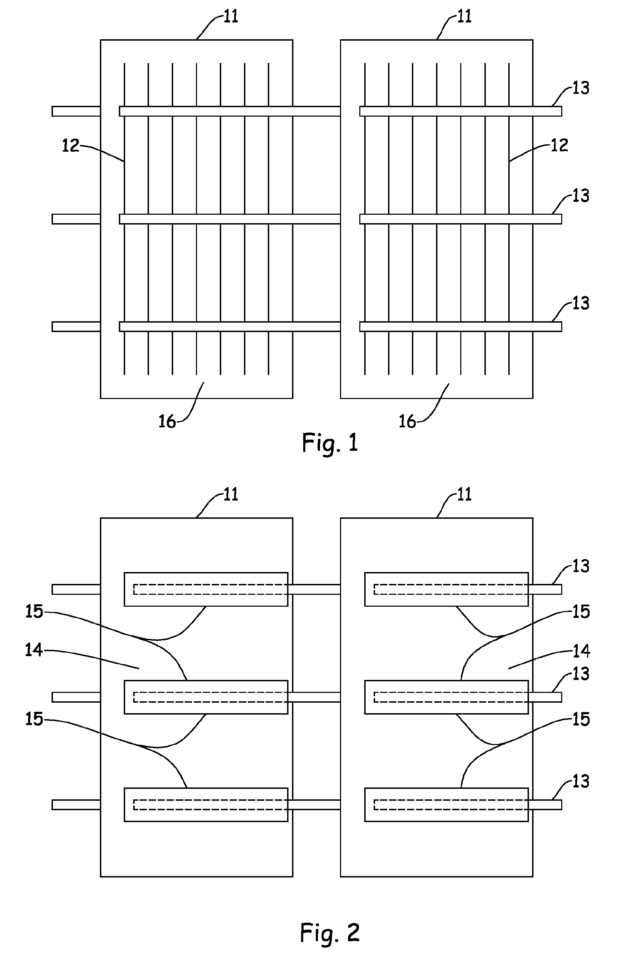

Figs. 1 and 2 show frontside and backside views respectively of an exemplary embodiment of the photovoltaic article of this invention in this case showing two adjacent photovoltaic cells 11. Each cell has a backside electrode 14 and a frontside electrical collection system 12, in this case shown as a series of thin wires, located on a topside transparent electrical contact 16 (region between the wires 12). According to one approach the topside electrical collector can extend beyond the edge of the first cell to contact the backside of the second cell. In this approach the electrical collection system also serves as the cell to cell electrical connector. This approach is not shown in Figs.1 and 2. Alternatively, as shown in Figs. 1 and 2 a separate electrical connector, in this case a conductive ribbon 13 is provided to connect the frontside electrical collector 12 of the first cell to the backside electrode 14 of the second cell. Additional cells may be added to form a string of the length desired. The terminal cells will have electrical leads (not shown) provided to enable connection of the cell into a more complex array (formed by modules made of the subject string) or to an electric service system.

The photovoltaic cells 11 used in this invention may be any photovoltaic cells used in the industry. Examples of such cells include crystalline silicon, amorphous silicon, CdTe, GaAs, dye-sensitized solar cells (so-called Graetzel cells), organic/polymer solar cells, or any other material that converts sunlight into electricity via the photoelectric effect. However, the photoactive layer is preferably a layer of IB-IIIA-chalcogenide, such as IB-IIIA-selenides, IB-IIIA-sulfides, or IB-IIIA-selenide sulfides. More specific examples include copper indium selenides, copper indium gallium selenides, copper gallium selenides, copper indium sulfides, copper indium gallium sulfides, copper gallium selenides, copper indium sulfide selenides, copper gallium sulfide selenides, and copper indium gallium sulfide selenides (all of which are referred to herein as CIGSS). These can also be represented by the formula CuIn(1-x)GaxSe(2-y)Sy where x is 0 to 1 and y is 0 to 2. The copper indium selenides and copper indium gallium selenides are preferred. CIGSS cells usually include additional electroactive layers such as one or more of emitter (buffer) layers, conductive layers (e.g. transparent conductive layer used on the top side) and the like as is known in the art to be useful in CIGSS based cells are also contemplated herein.

The cells have a backside electrode. Typically the backside electrode will comprise metal foils or films or will be such a foil, film or a metal paste or coating on a non-conductive or conductive substrate. Suitable materials include, but are not limited to metal foils or films of stainless steel, aluminum, titanium or molybdenum. Stainless steel and titanium are preferred. Preferably, the electrode structure including the substrate is flexible. The substrate can be coated with optional backside electrical contact regions on one or both sides of the substrate. Such regions may be formed from a wide range of electrically conductive materials, including one or more of Cu, Mo, Ag, Al, Cr, Ni, Ti, Ta, Nb, W combinations of these, and the like. Conductive compositions incorporating Mo may be used in an illustrative embodiment. Trace amounts or more of chalcogen containing substances may be found on the backside electrode surface, particularly when the photoactive layer is a IB-IIIA chalcogenide. These chalcogen substances may be residual from the formation process of the photoactive layer.

The cells will have a topside electrical collection system comprising a front electrode, which serves to collect photogenerated electrons from the photoactive region. The front electrode region 16 is formed over the photoactive region on the light incident surface of the photovoltaic device. In many embodiments, the front electrode comprises a transparent conductive layer (TCL). The TCL has a thickness in the range from about 10 nm to about 1500 nm, preferably about 100 nm to about 200 nm. The TCL may be a very thin metal film that has transparency to the relevant range of electromagnetic radiation or more commonly is a transparent conductive oxide (TCO). A wide variety of transparent conducting oxides (TCO) or combinations of these may be used. Examples include fluorine-doped tin oxide, tin oxide, indium oxide, indium tin oxide (ITO), aluminum doped zinc oxide (AZO), gallium doped zinc oxide, zinc oxide, combinations of these, and the like. In one illustrative embodiment, the TCL is indium tin oxide. TCO layers are conveniently formed via sputtering or other suitable deposition technique.

In some cases, the transparent conductive layer, may not be conductive enough to enable sufficient collection of electrons from the device. Thus, the front electrode region may also comprise an electrical collection system 12 (often a grid or mesh of thin wire lines) region. The grid region desirably at least includes conductive metals such as nickel, copper, silver, aluminum, tin, and the like and/or combinations thereof. In one illustrative embodiment, the grid comprises silver. Since these materials are not transparent, in one illustrative embodiment they are deposited as a grid or mesh of spaced apart lines so that the grid occupies a relatively small footprint on the surface (e.g., in some embodiments, the grid occupies about 10% or less, even about 5% or less, or even about 2% or less of the total surface area associated with light capture to allow the photoactive materials to be exposed to incident light). The grid region can be formed by one of several known methods including but not limited to screen printing, ink jet printing, electroplating, sputtering, evaporating and the like.

The grid electrical collection system may itself extend beyond the top edge of a cell to be contacted with the backside of an adjacent cell thus forming the electrical connector. More preferably as shown in Figs. 1 and 2 additional interconnect element(s) 13 that can be in the form of one or more thin wires or ribbons or wire mesh are provided. The interconnect elements are comprised of one or more conductive metals such as Cu, Ag, Sn, Al, Au, Fe:Ni, W, Ti, and the like. In preferred embodiments, the interconnect elements comprise a Cu or Fe:Ni ribbon that is coated with a thin layer of Sn or Sn:Ag. The interconnect elements connect adjacent cells and can also be used to connect the cells to external circuitry such as terminal bars. In an exemplary embodiment, the interconnect elements are connected to terminal bars at the leading and trailing edges of the interconnected cell assembly.

It is desirable to limit the amount of shading to the photoactive portion caused by interconnect elements and collection system, while providing enough conductive material to provide electrical continuity that maximizes efficiency of the cell. The interconnect elements can optionally be adhered to the topside of the photovoltaic cell (often a transparent conductive layer or collection grid) by use of an adhesive. The adhesive is typically an electrically conductive adhesive or solder material, but other non-conductive adhesives may also be used. Electrically conductive adhesives typically comprise a binder element, such as epoxy, acrylate, silicone and the like and a conductive filler comprising metal particles of a conductive material such as Cu, Ag, C, Al, combinations of these and the like. In exemplary embodiments, the adhesive is a silver filled epoxy resin.

As noted previously, an extension of the topside electrical collector or a conductive ribbon will serve as the electrical connector, extending beyond the edge of the first cell to enable it to contact the backside of the adjacent cell. This electrical connector can be connected to the backside electrode by the use of one or more of the adhesive or solder materials described above for the topside connection, preferably by an electrically conductive adhesive such as a silver filled epoxy resin.

In order to enhance the long term stability of the string or module to environmental stress, a conductive patch 15 is then place over a portion of the electrical connector and the backside electrode so that the conductive patch makes electrical contact with both the backside electrode and the electrical connector. The conductive patch preferably is provided such that it encapsulates at least a portion of the electrical connector. In the case of two or more electrical connectors (e.g.. ribbons) serving as the electrical connector, each electrical connector may have a separate conductive patch or a large conductive patch may extend over the entire region covering the ends of the electrical connector. The conductive patch can be made from a wide range of materials that are both conductive and will adhere to both the backside electrode of the photovoltaic device and the interconnect elements. It is desirable that this conductive patch has a relatively low electrical resistance (preferably less than about 0.01 Ohm-cm, more preferably less than about 0.005 Ohm-cm, most preferably less than 0.001 Ohm-cm). In one embodiment, the conductive patch may be in the form of electrically conductive foils or conductive adhesive tape, or any like structure that performs the above mentioned function. Suitable conductive tapes may be conductive foils comprising Cu or Al and can be plated with Ag, Sn or Ni.or other conductive metals. The tape will include an adhesive which is preferably conductive. However, if a non-conductive adhesive is used on the metal foil, embossing or scribing the adhesive on the tape will allow conductive contact between the surfaces. Commercially available examples of such conductive tapes include 1345 or 1183 from 3M or EL-90038 or EL-92708 from Adhesives Research. The 1345 conductive tape from 3M is an embossed metal foil tape with a non-conductive adhesive. The 1183 conductive tape from 3M and the EL-90038 and EL-92708 from Adhesives Research are metal foil tapes with a conductive adhesive. In one illustrative embodiment, the conductive tape is a Sn plated Cu foil with an electrically conductive adhesive. In another embodiment, the conductive element can be a low melting metal or solder that is provided over the interconnect element and in electrical contact with the backside electrode. The low melting metal or solder should have a melting point between 90 to 450°C, more preferably between 140 to 230°C, even more preferably between 150 to 190°C. Typical materials can be selected from those comprising Sn, Pb, In, Ag, Bi, Zn, Cd, Cu, combinations thereof and the like. In an exemplary embodiment, the conductive element is indium.

In yet another embodiment, the conductive element may be an electrically conductive adhesive. Suitable electrically conductive adhesives include, but are not limited to those with conductive Ag, Cu, Au, C or other conductive material filled adhesive. In an exemplary embodiment, the conductive element comprises a silver filled electrically conductive epoxy adhesive.

In another aspect of the invention, the photovoltaic article or interconnected cell assembly may be connected to terminal bars at one or both ends of the string, or at other regions as necessary to connect the module to external circuitry. In an exemplary embodiment, an interconnect element is connected from the backside electrode of the first photovoltaic cell to a terminal bar at the leading edge of the interconnected assembly, and an interconnect element is also connected from the topside electrode of the last photovoltaic cell to a terminal bar at the trailing edge of the interconnected assembly. It is contemplated that the connection may be created and/or maintained between the interconnect element and the terminal bar via a wide variety of joining techniques including but not limited to welding, soldering, or electrically conductive adhesive.

It is contemplated that the photovoltaic article may further comprise optional encapsulant layers that may perform several functions. For example, the encapsulant layers may serve as a bonding mechanism, helping hold the adjacent layers of the module together. It should also allow the transmission of a desirous amount and type of light energy to reach the photovoltaic cell (e.g. the photoactive portion). The encapsulant layers may also function to compensate for irregularities in geometry of the adjoining layers or translated though those layers (e.g. thickness changes). It also may serve to allow flexure and movement between layers due to environmental factors (e.g. temperature change, humidity, etc.) and physical movement and bending. In a preferred embodiment, first encapsulant layer may consist essentially of an adhesive film or mesh, but is preferably a thermoplastic material such as EVA (ethylene-vinyl-acetate), thermoplastic polyolefin, silicone, or similar material. It is contemplated that the encapsulant layers may be comprised of a single layer or may be comprised of multiple layers (e.g. a first, second, third, fourth, fifth layer, etc. The preferred thickness of this layer can range from about 0.1mm to 1.0mm, more preferably from about 0.2mm to 0.8mm, and most preferably from about 0.25mm to 0.5mm.

Additional front and backside barrier layers may also be used. Frontside barriers must be selected from transparent or translucent materials. These materials may be relatively rigid or may be flexible. Glass is highly useful as a frontside environmental barrier to protect the active cell components from moisture, impacts and the like. A backside barrier or backsheet may also be used. It is preferably constructed of a flexible material (e.g. a thin polymeric film, a metal foil, a multi-layer film, or a rubber sheet). In a preferred embodiment, the back sheet material may be moisture impermeable and also range in thickness from about 0.05mm to 10.0 mm, more preferably from about 0.1mm to 4.0mm, and most preferably from about 0.2mm to 0.8mm. Other physical characteristics may include: elongation at break of about 20% or greater (as measured by ASTM D882); tensile strength or about 25MPa or greater (as measured by ASTM D882); and tear strength of about 70kN/m or greater (as measured with the Graves Method). Examples of preferred materials include glass plate, aluminum foil, Tedlar® (a trademark of DuPont) or a combination thereof. A supplemental barrier sheet which is connectively located below the back sheet. The supplemental barrier sheet may act as a barrier, protecting the layers above from environmental conditions and from physical damage that may be caused by any features of the structure on which the PV device 10 is subjected to (e.g. For example, irregularities in a roof deck, protruding objects or the like). It is contemplated that this is an optional layer and may not be required. Alternately the protective layer could be comprised of more rigid materials so as to provide additional roofing function under structural and environmental (e.g. wind) loadings. Additional rigidity may also be desirable so as to improve the coefficient of thermal expansion of the PV device and maintain the desired dimensions during temperature fluctuations. Examples of protective layer materials for structural properties include polymeric materials such polyolefins, polyester amides, polysulfone, acetel, acrylic, polyvinyl chloride, nylon, polycarbonate, phenolic, polyetheretherketone, polyethylene terephthalate, epoxies, including glass and mineral filled composites or any combination thereof.

In addition to the encapsulant and barrier materials, a framing material may also be provided to enable attachment of the photovoltaic article to structures such as buildings and to enable and protect electrical interconnects between articles and from articles to other electrical devices. See for example the frame, preferably prepared by injection molding around a laminate structure, to form a building integrated photovoltaic device as shown in WO 2009/137353.

The advantage of the invention described is reflected in the stability of the photovoltaic strings and modules when exposed to environmental stress such as ambient heat. During the exposure, the solar cell laminates as described in Example 1 are positioned vertically on a stainless steel fixture within an oven held at 85°C ± 2°C. Module electrical performance is mathematically extracted from a current-voltage (I-V) characteristic curve that is measured prior to environmental exposure and at various intervals using a Spire 4600 class AAA solar simulator under AM1.5,1000 w/m². During the I-V characteristic measurement, the temperature of the module is maintained at 25°C. The I-V characteristic measurement apparatus and procedure meet the requirements specified in the IEC 60904 (parts 1 - 10) and 60891 standards. Immediately following this measurement the devices are returned to the ambient heat environment for the next test period. This process is repeated for each time period. For each I-V measurement, electrical contact is established at the electrical connectors attached to the terminal bars at the leading and trailing ends of the electrical assembly. The power is measured by varying the resistive load between open and closed circuit. The maximum power (Pmax) is calculated as the area of the largest rectangle under the current-voltage (I-V) characteristic curve. The series resistance (Rs) is the slope of the line near open-circuit voltage (Voc), not taken from a diode fit. The Pmax and Rs measurements for the electrically conductive patch are shared in the examples below.

### Examples

### EXAMPLE 1

5-cell photovoltaic strings of commercially available CIGS cells were obtained from Global Solar Energy in which the five cells were connected in series with three interconnect elements (ribbons) per cell joining the topside electrode of each cell to the backside electrode of the adjacent cell. Three leading interconnect elements were provided on the backside electrode of the first cell, with a portion of each ribbon extending beyond the leading edge of the first cell. Similarly, three trailing ribbons were attached to the topside of the last cell, with a portion of each ribbon extending beyond the trailing edge of the last cell. All interconnect ribbons copper coated with a tin/silver alloy were 2.5 mm wide and had a thickness of approximately 0.1 mm. Grid is silver filled organic. All interconnect ribbons were attached to the frontside electrodes and backside electrodes using a silver filled electrically conductive epoxy adhesive. One piece of 3M^{®} 1383 EMI shielding tape of ½ inch width was applied along the length of each ribbon for each cell so that the conductive tape encapsulated the full length and width of the interconnect elements. The ends of the trailing and leading interconnect ribbons were then welded to terminal bars on each end of the string via resistance welding. The terminal bars were pre-fixtured to further electrical components consisting of a home run wire, a diode wire and electrical connectors. The strings were then laid up into a pre-laminate format in the following order: Glass/polyolefin encapsulant/string & electrical assembly/polyolefin encapsulant/backsheet/polyolefin encapsulant/TPO. The pre-laminate was then laminated in a clamshell type laminator at 150°C. After the laminates were formed, the solar cell laminates were placed into environmental exposure chambers for stability testing. The photovoltaic performance figures of merit obtained at various intervals during ambient exposure to 85°C conditions are shown in the table below (sample size of 6):

| Exposure Hours | Normalized Pmax | Normalized Rs |
|---|---|---|
| 0 | 1.00 | 1.00 |
| 110 | 1.03 | 0.90 |
| 745 | 1.02 | 0.89 |
| 1073 | 1.02 | 0.90 |
| 1345 | 0.97 | 1.02 |
| 1683 | 1.00 | 1.01 |
| 2036 | 0.94 | 1.17 |

### EXAMPLE 2

5-cell solar cell laminates were fabricated in the same manner as example 1, except that indium metal was used as the conductive element encapsulating the interconnect elements on the back contact in place of conductive tape. The indium was applied in liquid form by heating indium pellets during application. The liquid indium was spread over the interconnect elements so that indium was contacting both the backside electrode and the interconnect element, and a substantial portion of the interconnect element at the back of the cell was completely encapsulated with indium. The indium was then allowed to cool to room temperature. After the laminates were formed, the solar cell laminates were placed into environmental exposure chambers for stability testing. The photovoltaic performance figures of merit obtained at various intervals during ambient exposure to 85°C conditions are shown in the table below (sample size of 5-6):

| Exposure Hours | Normalized Pmax | Normalized Rs |
|---|---|---|
| 0 | 1.00 | 1.00 |
| 110 | 1.00 | 0.94 |
| 745 | 1.02 | 0.87 |
| 1073 | 1.00 | 0.93 |
| 1345 | 0.99 | 0.96 |
| 1683 | 1.02 | 0.96 |
| 2036 | 0.98 | 1.03 |

### EXAMPLE 3

5-cell solar cell laminates were fabricated in the same manner as example 1, except that ECM 1541-S electrically conductive adhesive was used as the conductive element encapsulating the interconnect elements in place of conductive tape. The electrically conductive adhesive was spread over the interconnect elements so that electrically conductive adhesive was contacting both the backside electrode and the interconnect element, and a substantial portion of the interconnect element at the back of the cell was completely encapsulated with electrically conductive adhesive. The electrically conductive adhesive was cured at 160°C for 30 minutes and then the solar cell strings were allowed to cool before preparing laminates in the same manner as described in example 1. After the laminates were formed, the solar cell laminates were placed into environmental exposure chambers for stability testing. The photovoltaic performance figures of merit obtained at various intervals during ambient exposure to 85°C conditions are shown in the table below (sample size of 6):

| Exposure Hours | Normalized Pmax | Normalized Rs |
|---|---|---|
| 0 | 1.00 | 1.00 |
| 110 | 1.03 | 0.93 |
| 745 | 1.05 | 0.86 |
| 1073 | 1.05 | 0.87 |
| 1345 | 1.04 | 0.90 |
| 1683 | 1.05 | 0.95 |
| 2036 | 0.99 | 1.10 |

### COMPARATIVE EXAMPLE 4

5-cell solar cell laminates were fabricated in the same manner as example 1, except that no conductive element was provided. After the laminates were formed, the solar cell laminates were placed into environmental exposure chambers for stability testing. The photovoltaic performance figures of merit obtained at various intervals during ambient exposure to 85°C conditions are shown in the table below (sample size of 6):

| Exposure Hours | Normalized Pmax | Normalized Rs |
|---|---|---|
| 0 | 1.00 | 1.00 |
| 110 | 1.01 | 0.96 |
| 745 | 0.69 | 1.91 |
| 1073 | 0.58 | 2.61 |
| 1345 | 0.51 | 3.17 |
| 1683 | 0.60 | 2.43 |
| 2036 | 0.57 | 2.27 |

## Claims

1. A photovoltaic article comprising a first photovoltaic cell having a photoelectrically active region which is located between a topside electrode and a backside electrode, and an electrical connector in contact with the backside electrode on the backside of the cell and is connected to the backside electrode by use of an electrically conductive adhesive or solder, wherein an electrically conductive patch is located over at least a portion of and in electrical contact with both the backside electrode and the connector.

2. The photovoltaic article of claim 1 further comprising an additional photovoltaic cell adjacent to the first photovoltaic cell where the additional photovoltaic cell has a photoelectrically active region which is located between a topside electrode and a backside electrode, wherein the electrical connector in contact with the backside of the first photovoltaic cell is in contact with an electrically conducting element of the second photovoltaic cell.

3. The article of claim 2 wherein the electrical connector in contact with the backside of the first photovoltaic cell is in contact with the topside electrode of the second photovoltaic cell.

4. The photovoltaic article of claim 3 wherein there are one or more additional photovoltaic cells each adjacent to another photovoltaic cell, each cell having a photoelectrically active region which is located between a topside electrode and a backside electrode and connecting each adjacent cell is one or more electrical connectors in contact with the topside electrode of one cell and the backside electrode of the adjacent cell to form a series of interconnected cells, where at least a portion of the backside electrode and the electrical connector in contact with it are covered by a conductive patch.

5. The photovoltaic article of any one of claims 1-4, wherein the conductive patch comprises one or more of conductive tape, electrically conductive adhesive or low melting metal or solder material.

6. The photovoltaic article of claim 5, wherein the conductive patch comprises a metallic or intermetallic composition with a melting temperature lower than about 300°C.

7. The photovoltaic article of claim 5, wherein the conductive patch comprises an electrically conductive epoxy adhesive.

8. The photovoltaic article of claim 6 wherein the conductive patch comprises indium.

9. The photovoltaic article of any of the preceding claims, wherein the electrical connectors are attached to the topside electrode and/or the backside electrode using electrically conductive adhesive.

10. The photovoltaic article of any of the preceding claims, wherein the electrical connector comprises a wire mesh.

11. A photovoltaic article according to any of the preceding claims further comprising a backside support, a frontside transparent barrier material, and electrical connections to enable transfer of electricity generated in the photovoltaic cell to other electrical devices.

12. The article of claim 11 further comprising an encapsulant material between the backside support and the backside electrode and an encapsulant material between the topside electrode and the frontside transparent barrier.

13. The article of claim 11 or 12 wherein the frontside transparent barrier is flexible.

14. The article of claim 11 or 12 wherein the frontside transparent barrier is glass.

15. The photovoltaic article of any one of claims 11-14 further comprising a polymeric frame around at least a portion of the stack comprising the backside support, photovoltaic cell and electrical connectors and frontside transparent barrier material.

## Patentansprüche

1. Ein photovoltaischer Artikel, beinhaltend eine erste photovoltaische Zelle mit einem photoelektrisch aktiven Bereich, der sich zwischen einer oberen Elektrode und einer rückseitigen Elektrode befindet, und einen elektrischen Anschluss in Kontakt mit der rückseitigen Elektrode auf der Rückseite der Zelle und der mit der rückseitigen Elektrode durch Verwendung eines elektrisch leitenden Haftmittels oder Lötmittels verbunden ist, wobei sich eine elektrisch leitende Stelle über mindestens einem Abschnitt von sowohl der rückseitigen Elektrode als auch dem Anschluss befindet und in elektrischem Kontakt mit diesen ist.

2. Photovoltaischer Artikel gemäß Anspruch 1, ferner beinhaltend eine zusätzliche photovoltaische Zelle, angrenzend an der ersten photovoltaischen Zelle, wobei die zusätzliche photovoltaische Zelle einen photoelektrisch aktiven Bereich aufweist, der sich zwischen einer oberen Elektrode und einer rückseitigen Elektrode befindet, wobei der elektrische Anschluss in Kontakt mit der Rückseite der ersten photovoltaischen Zelle in Kontakt mit einem elektrisch leitenden Element der zweiten photovoltaischen Zelle ist.

3. Artikel gemäß Anspruch 2, wobei der elektrische Anschluss in Kontakt mit der Rückseite der ersten photovoltaischen Zelle in Kontakt mit der oberen Elektrode der zweiten photovoltaischen Zelle ist.

4. Photovoltaischer Artikel gemäß Anspruch 3, wobei eine oder mehrere zusätzliche photovoltaische Zellen jeweils angrenzend an einer weiteren photovoltaischen Zelle vorhanden sind, wobei jede Zelle einen photoelektrisch aktiven Bereich aufweist, der sich zwischen einer oberen Elektrode und einer rückseitigen Elektrode befindet, und wobei, jede angrenzende Zelle verbindend, ein oder mehrere elektrische Anschlüsse vorhanden ist/sind, die in Kontakt mit der oberen Elektrode einer Zelle und der rückseitigen Elektrode der benachbarten Zelle ist/sind, um eine Reihe von miteinander verbundenen Zellen zu bilden, wobei mindestens ein Abschnitt der rückseitigen Elektrode und des elektrischen Anschlusses in Kontakt damit durch eine leitende Stelle bedeckt ist.

5. Photovoltaischer Artikel gemäß einem der Ansprüche 1-4, wobei die leitende Stelle eines oder mehrere von einem leitenden Band, elektrisch leitenden Haftmittel oder niedrigschmelzenden Metall oder Lötmittelmaterial beinhaltet.

6. Photovoltaischer Artikel gemäß Anspruch 5, wobei die leitende Stelle eine metallische oder intermetallische Zusammensetzung mit einer Schmelztemperatur, die niedriger als etwa 300 °C ist, beinhaltet.

7. Photovoltaischer Artikel gemäß Anspruch 5, wobei die leitende Stelle ein elektrisch leitendes Epoxidhaftmittel beinhaltet.

8. Photovoltaischer Artikel gemäß Anspruch 6, wobei die leitende Stelle Indium beinhaltet.

9. Photovoltaischer Artikel gemäß einem der vorhergehenden Ansprüche, wobei die elektrischen Anschlüsse unter Verwendung von elektrisch leitendem Haftmittel an der oberen Elektrode und/oder der rückseitigen Elektrode angebracht sind.

10. Photovoltaischer Artikel gemäß einem der vorhergehenden Ansprüche, wobei der elektrische Anschluss ein Drahtgewebe beinhaltet.

11. Photovoltaischer Artikel gemäß einem der vorhergehenden Ansprüche, der ferner eine rückseitige Stütze, ein vorderes transparentes Sperrmaterial und elektrische Verbindungen, um den Transfer von Elektrizität, erzeugt in der photovoltaischen Zelle, auf andere elektrische Vorrichtungen zu ermöglichen, beinhaltet.

12. Artikel gemäß Anspruch 11, der ferner ein Verkapselungsmaterial zwischen der rückseitigen Stütze und der rückseitigen Elektrode und ein Verkapselungsmaterial zwischen der oberen Elektrode und der vorderen transparenten Sperre beinhaltet.

13. Artikel gemäß Anspruch 11 oder 12, wobei die vordere transparente Sperre biegsam ist.

14. Artikel gemäß Anspruch 11 oder 12, wobei die vordere transparente Sperre Glas ist.

15. Photovoltaischer Artikel gemäß einem der Ansprüche 11-14, ferner beinhaltend einen Polymerrahmen um mindestens einen Abschnitt des Stapels, beinhaltend die rückseitige Stütze, photovoltaische Zelle und die elektrischen Anschlüsse und das vordere transparente Sperrmaterial.

## Revendications

1. Un article photovoltaïque comprenant une première cellule photovoltaïque ayant une région photoéléctriquement active qui est située entre une électrode de dessus et une électrode dorsale, et un connecteur électrique en contact avec l'électrode dorsale sur le côté dorsal de la cellule et en connexion avec l'électrode dorsale à l'aide d'un adhésif ou d'une brasure électroconducteurs, dans lequel un timbre électroconducteur est situé par-dessus au moins une portion à la fois de l'électrode dorsale et du connecteur et en contact électrique avec ceux-ci.

2. L'article photovoltaïque de la revendication 1 comprenant en sus une cellule photovoltaïque supplémentaire adjacente à la première cellule photovoltaïque, la cellule photovoltaïque supplémentaire ayant une région photoélectriquement active qui est située entre une électrode de dessus et une électrode dorsale, dans lequel le connecteur électrique en contact avec le côté dorsal de la première cellule photovoltaïque est en contact avec un élément électroconducteur de la deuxième cellule photovoltaïque.

3. L'article de la revendication 2 dans lequel le connecteur électrique en contact avec le côté dorsal de la première cellule photovoltaïque est en contact avec l'électrode de dessus de la deuxième cellule photovoltaïque.

4. L'article photovoltaïque de la revendication 3 dans lequel il se trouve une ou plusieurs cellules photovoltaïques supplémentaires adjacentes chacune à une autre cellule photovoltaïque, chaque cellule ayant une région photoélectriquement active qui est située entre une électrode de dessus et une électrode dorsale et connectant chaque cellule adjacente se trouvent un ou plusieurs connecteurs électriques en contact avec l'électrode de dessus d'une cellule et l'électrode dorsale de la cellule adjacente afin de former une série de cellules interconnectées, où au moins une portion de l'électrode dorsale et le connecteur électrique en contact avec celle-ci sont recouverts par un timbre conducteur.

5. L'article photovoltaïque de l'une quelconque des revendications 1 à 4, dans lequel le timbre conducteur comprend un ou plusieurs éléments parmi un ruban conducteur, un adhésif électroconducteur ou un métal ou un matériau de brasure à bas point de fusion.

6. L'article photovoltaïque de la revendication 5, dans lequel le timbre conducteur comprend une composition métallique ou intermétallique avec une température de fusion inférieure à environ 300 °C.

7. L'article photovoltaïque de la revendication 5, dans lequel le timbre conducteur comprend un adhésif époxyde électroconducteur.

8. L'article photovoltaïque de la revendication 6 dans lequel le timbre conducteur comprend de l'indium.

9. L'article photovoltaïque de n'importe lesquelles des revendications précédentes, dans lequel les connecteurs électriques sont attachés sur l'électrode de dessus et/ou l'électrode dorsale à l'aide d'adhésif électroconducteur.

10. L'article photovoltaïque de n'importe lesquelles des revendications précédentes, dans lequel le connecteur électrique comprend un treillis métallique.

11. Un article photovoltaïque selon n'importe lesquelles des revendications précédentes comprenant en sus un support dorsal, un matériau formant barrière frontale transparente, et des connexions électriques afin de permettre le transfert d'électricité générée dans la cellule photovoltaïque vers d'autres dispositifs électriques.

12. L'article de la revendication 11 comprenant en sus un matériau encapsulant entre le support dorsal et l'électrode dorsale et un matériau encapsulant entre l'électrode de dessus et la barrière frontale transparente.

13. L'article de la revendication 11 ou de la revendication 12 dans lequel la barrière frontale transparente est flexible.

14. L'article de la revendication 11 ou de la revendication 12 dans lequel la barrière frontale transparente est du verre.

15. L'article photovoltaïque de l'une quelconque des revendications 11 à 14 comprenant en sus un cadre polymère autour d'au moins une portion de l'empilement comprenant le support dorsal, la cellule photovoltaïque et les connecteurs électriques et le matériau formant barrière frontale transparente.
